# EUROPEAN PATENT APPLICATION

(11) **EP 4 593 269 A1**
(43) Date of publication of application: **30.07.2025**
(21) Application number: 24219460.3
(22) Date of filing: 12.12.2024
(51) Int. Cl.: H02M 1/00, H02M 1/32, H02M 3/156, H02M 3/158, H05B 45/38, H02J 1/00

(54) **BATTERY CURRENT OPTIMIZATION SCHEME FOR HIGH POWER LASER APPLICATIONS**

(30) Priority: 26.01.2024 US 202418424473
(71) Applicant: Microsoft Technology Licensing, LLC, Redmond, WA 98052 (US)
(72) Inventor: Voong, Mike, Redmond, WA 98052 (US); Park, Chang Joon, Redmond, WA 98052 (US)
(74) Representative: Grünecker Patent- und Rechtsanwälte PartG mbB

(57) **Abstract**

Methods and apparatuses for improving the power efficiency of boost converters that power illumination sources, such as lasers or LEDs, are described. An adaptive driving strength scheme that dynamically controls a switch-on current for a boost converter based on an output voltage of the boost converter, a temperature, and a state of an illumination source powered by the boost converter are utilized to improve the power efficiency of the boost converter. A resistance of a switch transistor for the boost converter may be adjusted over time by dynamically adjusting a gate voltage applied to the switch transistor.

## Description

### BACKGROUND

Some computing systems provide a natural user interface in which the system may be controlled using gestures. These systems may include a color camera (e.g., an RGB camera) and/or a depth camera for capturing images of an environment to detect motion and identify gestures. The depth camera may comprise an active illumination depth camera that utilizes time-of-flight (TOF) or structured light techniques for obtaining depth information. The color camera may capture a portion of the environment as a color image and the depth camera may capture a portion of the environment as a depth map. A depth map may comprise a two-dimensional image of the environment that includes depth information relating to the distances to objects within the environment from a particular reference point, such as a point associated with the depth camera. Each pixel in the two-dimensional image may be associated with a depth value representing a linear distance from the particular reference point.

A variety of techniques may be used to generate a depth map such as structured light illumination and time of flight techniques. Structured light illumination involves projecting a light pattern into an environment, capturing an image of the reflected light pattern, and then determining distance information from the spacings and/or distortions associated with the reflected light pattern relative to the projected light pattern. The light pattern may be projected using light that is invisible to the naked eye (e.g., IR or UV light) and may comprise a single dot, a single line, or a variety of dimensional patterns (e.g., horizontal and vertical lines, or checkerboard patterns). Time of flight techniques may determine distances to objects within an environment by timing how long it takes for light transmitted from a light source to travel to the objects and reflect back to an image sensor. The transmitted light may be generated using a laser or light-emitting diode (LED).

### BRIEF SUMMARY

Systems and methods are provided for improving the power efficiency of boost converters that power illumination sources, such as lasers and LEDs. An adaptive driving strength scheme that controls a switch-on current for a boost converter based on an output voltage of the boost converter, a temperature associated with the boost converter, a temperature associated with the illumination source, and/or a state of the illumination source powered by the boost converter may be utilized to improve the power efficiency of the boost converter. The state of the illumination source may correspond with an amount of light that the illumination source is emitting or an amount of current being drawn by the illumination source. In some cases, a resistance of a switch transistor for the boost converter may be adjusted over time by dynamically adjusting a gate voltage applied to a gate of the switch transistor. During operation of the boost converter, the gate voltage applied to the gate of the switch transistor may be pulsed between 0V and a maximum pulse voltage that is set based on a load current, an output voltage of the boost converter, a temperature, and/or whether the boost converter is operating during an illumination phase or a recovery phase (or non-illumination phase).

According to some embodiments, the technical benefits of the systems and methods disclosed herein include reduced power and energy consumption during operation, improved battery life, and reduced manufacturing costs. Other technical benefits can also be realized through various implementations of the disclosed technologies.

This Summary is provided to introduce a brief description of some aspects of the disclosed technologies in a simplified form that are further described below in the Detailed Description. This Summary is not intended to identify key features or essential features of the claimed subject matter, nor is it intended that this Summary be used to limit the scope of the claimed subject matter. Furthermore, the claimed subject matter is not limited to implementations that solve any or all disadvantages noted in any part of this disclosure.

### BRIEF DESCRIPTION OF THE DRAWINGS

Like-numbered elements may refer to common components in the different figures.
Figure 1A depicts one embodiment of a boost converter.
Figure 1B depicts one embodiment of the boost converter of Figure 1A implemented using a diode.
Figure 1C depicts one embodiment of voltage and current waveforms during operation of the boost converter depicted in Figure 1A.
Figure 1D depicts one embodiment of the output voltage of a gate driver.
Figure 2 depicts one embodiment of a networked computing environment in which the disclosed technology may be practiced.
Figures 3A-3B depict a flowchart describing one embodiment of a process for operating a boost converter.

### DETAILED DESCRIPTION

The technologies described herein improve the power and energy efficiency of boost converters for powering high powered lasers and other light emitting devices. Depth cameras and other depth sensing systems may illuminate an environment (e.g., a room) using one or more high powered pulsed lasers, capture reflected light from the one or more high powered pulsed lasers, and then determine depth information based on the reflected light captured over time. From a power standpoint, some depth sensing systems may have a large power requirement when illuminating an environment during an illumination phase followed by a much smaller power requirement when integrating or processing data during a recovery phase. In one example, during an illumination phase lasting 1 ms, a system may see upwards of 150W of power draw, potentially shutting down the system prematurely, and then during a recovery phase (or a non-illumination phase) lasting 4ms, the system may only need to provide 1W or less of power. A depth sensing system may alternate between illumination phases and recovery phases while performing depth sensing operations.

One technical issue with powering illumination sources is that a high dynamic load on a battery for powering one or more pulsed lasers during the illumination phase may result in either the triggering of cell protection circuitry or the browning out of the system. These technical issues may affect the performance of TOF sensors and depth sensing circuitry utilizing transmitted and reflected light from lasers and light-emitting devices to determine depth information. Technical benefits of taking advantage of the amount of time during a recovery phase or during time periods without illumination to dynamically adjust the supply current and/or the switch-on current used by a boost converter include improved power efficiency and longer battery life. Moreover, boost converters with the ability to adjust power efficiency based on the operating conditions of an illumination source allow for the use of lighter weight batteries for mobile devices. Further, as weight is an important factor for head-mounted display devices (HMDs) that provide an augmented reality environment or a mixed reality environment, boost converters with improved power efficiency and longer battery life may lead to an HMD with reduced weight and size.

In some embodiments, an adaptive driving strength scheme that controls the switch-on current for a boost converter (or boost regulator) based on an output voltage of the boost converter, a temperature associated with the boost converter, a temperature associated with an illumination source powered by the boost converter, and/or an operating state of the illumination source may improve the power efficiency of the boost converter while maintaining illumination performance for the illumination source. An operating state of the illumination source may correspond with an amount of light being generated by the illumination source. In one example, a first operating state may correspond to the illumination source emitting light or more than a threshold amount of light and a second operating state may correspond to the illumination source not emitting light or emitting less than a threshold amount of light. An operating state of the illumination source may correspond with an amount of current drawn by the illumination source. In one example, a first operating state may correspond to the illumination source drawing more than 10A of current and a second operating state may correspond to the illumination source drawing less than 1A of current.

A boost converter may comprise a DC-DC switching converter that increases (or steps-up) an input voltage to a higher output voltage. In one example, the boost converter may generate a 27V output voltage given a 6V input voltage. The boost converter may generate an increased output voltage by storing energy in an inductor during a switch-on phase and then releasing the stored energy to an output load during a switch-off phase. The switch-on current for the boost converter may correspond to the current through the inductor during the switch-on phase. The switch-on current may be set based on a voltage applied to a gate of a switch transistor for the boost converter during the switch-on phase.

In some cases, a resistance of a switch transistor for the boost converter may be adjusted over time by dynamically adjusting a gate voltage applied to a gate of the switch transistor. The resistance of the switch transistor may set the switch-on current for the boost converter during a switch-on phase. The gate voltage applied to the switch transistor may be determined based on an amount of current required by a load driven by the boost converter, an output voltage of the boost converter, a temperature of the boost converter, a temperature of an illumination source, and/or whether the boost converter is operating during an illumination phase or a recovery phase. In one example, the gate voltage applied to the switch transistor may be adjusted by adjusting a supply voltage used by a gate driver for generating or selecting the gate voltage applied to the switch transistor. In some cases, the gate voltage applied to the switch transistor may be set to a first select voltage (e.g., to VG1 equal to 5V) if the output voltage of the boost converter is greater than a first voltage (e.g., is greater than 16V); otherwise, the gate voltage applied to the switch transistor may be set to a second select voltage (e.g., VG2 equal to 7V) greater than the first voltage if the output voltage of the boost converter is not greater than the first select voltage or is less than the first select voltage. The first select voltage may be adjusted over time based on whether the boost converter is operating during an illumination phase or a recovery phase. The first select voltage may be adjusted over time based on the temperature of the boost converter or the temperature of the illumination source. The temperature of the boost converter may be determined using an on-die temperature sensor.

In some cases, the gate voltage applied to a switch transistor for a boost converter may be increased by using a higher power supply for a gate driver circuit for outputting the gate voltage applied to the switch transistor when an output voltage of the boost converter (VOUT) falls below a threshold level which is set by a control circuit, such as a Microcontroller Unit (MCU), or is set by a lookup table of threshold values based on whether the boost converter is operating during an illumination phase or a recovery phase. An increase in the gate voltage applied to the gate of the switch transistor may reduce the on-resistance of the switch transistor and increase the switch-on current flowing through the switch transistor.

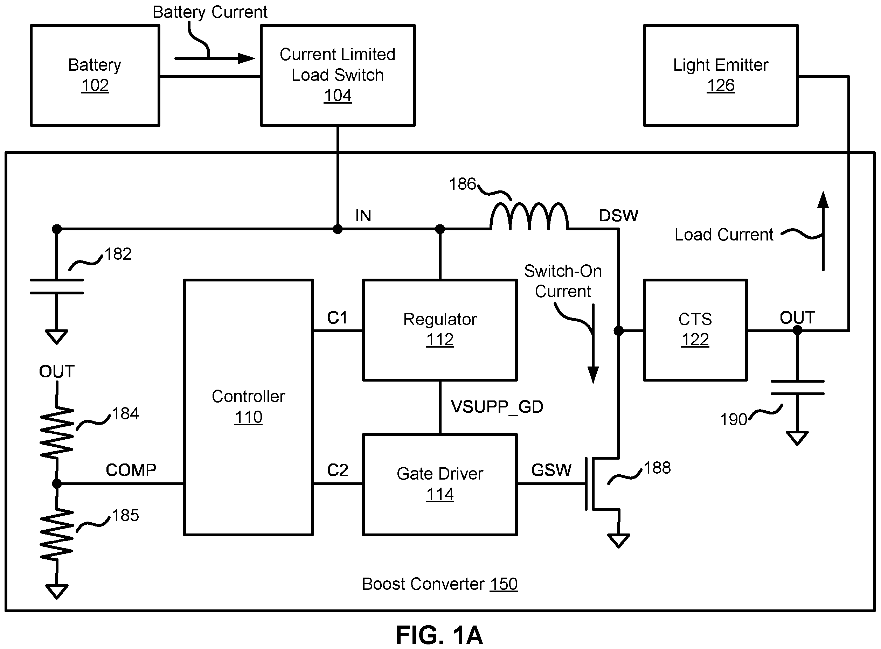

Figure 1A depicts one embodiment of a boost converter 150 driving an illumination source comprising light emitter 126. The light emitter 126 may comprise a high-powered laser or an LED. The boost converter 150 is powered by a battery 102 in series with a current limited load switch 104 that limits the amount of current drawn from the battery 102. In one example, the current limited load switch 104 limits the amount of current drawn from the battery 102 to at most 10mA.

The boost converter 150 includes an inductor 186 in series with a switch transistor 188. The switch transistor 188 may comprise an NMOS transistor. The boost converter may operate using a switch-on phase (when the switch transistor is conducting current) and a switch-off phase (when the switch transistor is cut-off and is not conducting current). During the switch-on phase, the switch-on current flows through the inductor 186, through the switch transistor 188, and into the ground node. During the switch-on phase, the current through the inductor 186 may increase over time causing the energy content of the inductor's magnetic field to increase. During the switch-on phase, if the voltage at node DSW is less than the voltage at node OUT, then the charge transfer switch (CTS) 122 may prevent current from flowing from the node OUT to the node DSW. The CTS 122 may be implemented using a diode or a transistor that is controlled such that current may only flow from the node DSW to the node OUT. The CTS 122 may comprise a device that provides asymmetric conductance such that currently flows in only one direction from the node DSW to the node OUT. During the switch-on phase, a load current may flow from the node OUT to the light emitter 126. The capacitor 190 may be sized such that the voltage at node OUT does not fall below a minimum output voltage for the boost converter during the illumination phase.

During the switch-off phase, when the switch transistor 188 is cut-off or set into a non-conducting state, the inductor 186 will resist changes in current flow causing the node DSW to increase. Once the voltage of the node DSW increases above the voltage at the node OUT plus any voltage drop required by the CTS 122, then current will flow from the node DSW to the node OUT causing the voltage at node OUT to increase.

As depicted in Figure 1A, the battery 102 is connected in series with the current limited load switch 104 that drives node IN. The voltage at node IN may comprise the input voltage for the boost converter 150. A capacitor 182 is connected between the node IN and the ground node. The inductor 186 is arranged between the node IN and the node DSW. The switch transistor 188 is arranged between the node DSW and the ground node. The gate driver 114 takes a power supply input from the node VSUPP_GD and generates a gate voltage at the node GSW for the switch transistor 188. The regulator 112 generates a supply voltage for the gate driver 114 at node VSUPP_GD and takes a power supply input from the node IN. A controller 110 is connected to the regulator 112 and the gate driver 114 to provide control signals C1 and C2 for generating configurable voltages at nodes VSUPP_GD and GSW. A voltage divider comprising resistors 184-185 is used to generate a voltage at node COMP that is less than the voltage of the node OUT. A charge transfer switch (CTS) 122 is arranged between the node DSW and the node OUT. A capacitor 190 is arranged between the node OUT and the ground node. The capacitor 190 may represent the capacitance of a bank of capacitors connected to the output node OUT. The node OUT may be used as a power supply for the light emitter 126.

In some cases, the controller 110, regulator 112, and gate driver 114 may comprise a control circuit or a portion of the control circuit for adjusting the voltage at the node GSW during operation of the boost converter 150.

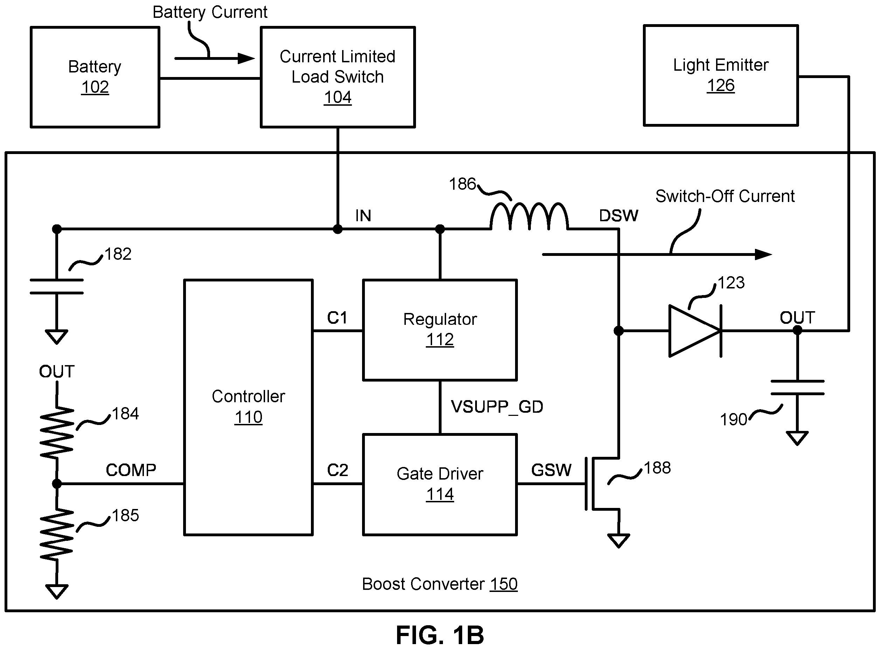

Figure 1B depicts one embodiment of the boost converter 150 of Figure 1A in which the CTS 122 is implemented using a diode 123. The current limited load switch 104 may limit the battery current flowing from the battery 102 such that the instantaneous current draw from the battery 102 is always less than a maximum current (e.g., does not exceed 3.3A). The limited current from the battery 102 may slow down the ability of the boost converter 150 to replenish the charge on the capacitor 190 and to maintain at least a minimum output voltage at the node OUT. The capacitor 190 may comprise a bank of capacitors. The boost converter 150 may boost the input voltage at node IN to a voltage greater than the input voltage without exceeding an absolute maximum voltage specification of downstream illumination sources such as the light emitter 126. A bank of capacitors connected to node OUT may be sized to provide the power needed for the entirety of any pulsed laser loads without falling below the Under Voltage Lock Out (UVLO) voltage of the downstream illumination sources.

In some cases, the controller 110 may include a comparator for comparing the voltage at node COMP with a reference voltage in order to detect that the voltage at the output node OUT has fallen below a threshold level (e.g., has fallen below 18V). The reference voltage may be derived from a bandgap-based voltage reference. Voltage comparator circuits may be used to determine whether the voltage at the node OUT has fallen below a first threshold level or has risen above a second threshold level. The controller 110 may include a temperature sensor or be in communication with a temperature sensor that determines a temperature of the boost converter or a temperature of an illumination source. The controller 110 may configure the control signals C1 and C2 to adjust the voltage of the node GSW to increase the switch-on current through the switch transistor 188 in response to detecting that the voltage at the output node OUT has fallen below a threshold level (e.g., has fallen below 18V).

The regulator 112 may include a non-inverting amplifier with a configurable voltage divider for generating a supply voltage for the gate driver 114. The control signal C1 may configure resistance settings for the configurable voltage divider such that the power supply input from the node VSUPP_GD is set to a particular voltage (e.g., 12V). The gate driver 114 may include a configurable resistive ladder, an analog multiplexor, and a unity gain buffer for driving the node GSW. The control signal C2 may configure resistance settings for the configurable resistive ladder that may generate a voltage that is a ratio of the voltage at the node VSUPP_GD. The voltage to be applied to the gate of the switch transistor 188 may be selected using the analog multiplexor that is connected to various nodes of the configurable resistive ladder and buffered using the unity gain buffer.

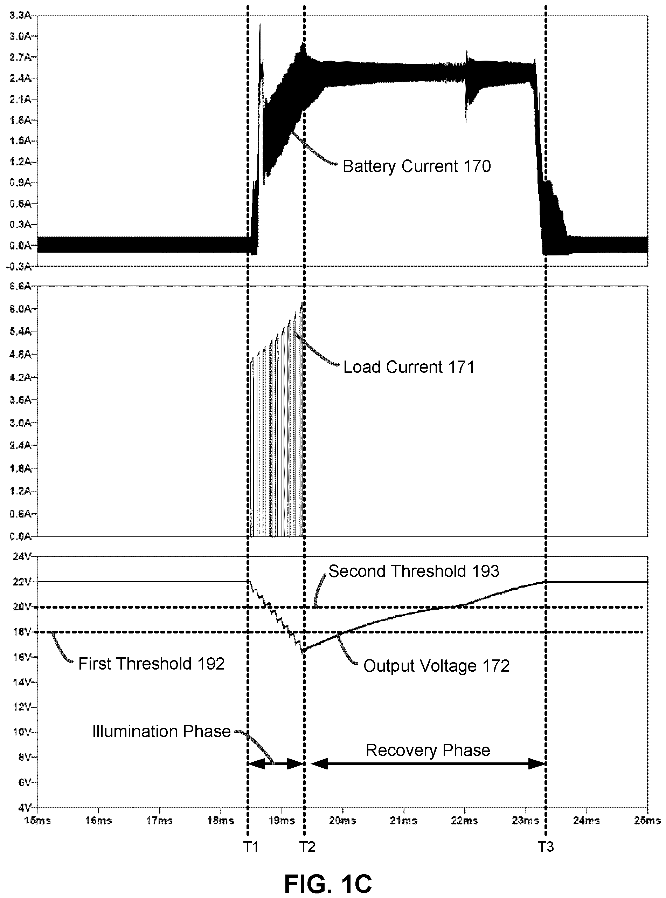

Figure 1C depicts one embodiment of voltage and current waveforms during operation of the boost converter depicted in Figure 1A. The current waveforms include the battery current 170 that flows from the battery 102 in Figure 1A to the current limited load switch 104 and the load current 171 that flows from the node OUT in Figure 1A to the light emitter 126. The voltage waveform includes the output voltage 172 that is the voltage at the node OUT in Figure 1A. Prior to time T1 and subsequent to time T2, the load current 171 is 0A. Between times T1 and T2, the load current 171 pulses between 0A and a pulse height that varies between 4.6A and 6.0A. The time period between times T1 and T2 corresponds to an illumination phase in which an illumination source is generating light and the time period between T2 and T3 corresponds to a recovery phase in which the illumination source does not generate light. In one example, the illumination phase is 1ms in duration and the recovery phase is 4ms in duration. The current limited load switch 104 may limit the battery current 170 to less than 3.3A during operation.

As depicted in Figure 1C, the output voltage 172 is held at 22V until time T1 when the load current 171 being drawn from the output node OUT causes the output voltage 172 to fall from 22V at time T1 to close to 16V at time T2. At time T3, the load current 171 falls to 0A and the output voltage 172 rises from close to 16V at time T2 to 22V at time T3.

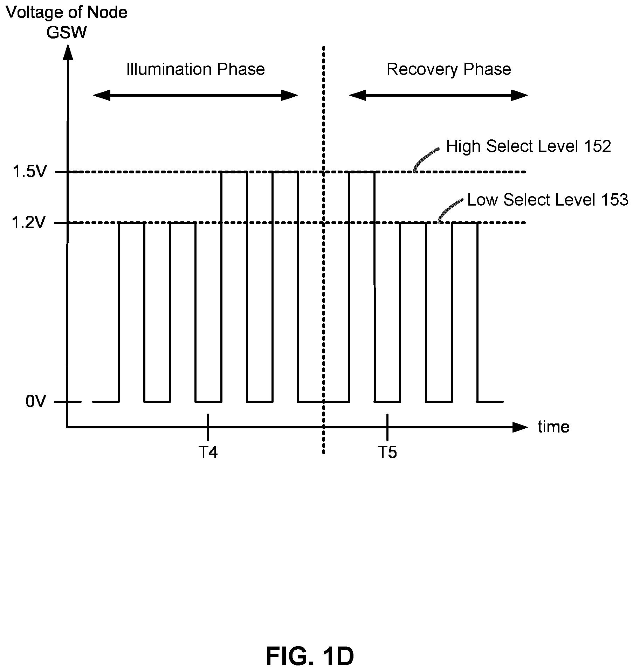

Figure 1D depicts one embodiment of the output voltage of the gate driver 114 in Figure 1A that drives the gate of the switch transistor 188 in Figure 1A. The output of the gate driver 114 in Figure 1A drives the node GSW.

In reference to Figure 1C, during the illumination phase and while the node OUT is greater than the first threshold 192 (e.g., is greater than 18V), the boost converter 150 in Figure 1A may toggle the node GSW or pulse the node GSW between 0V and a low select level 153 of 1.2V. Then, after the node OUT falls below the first threshold 192 at time T4 (e.g., corresponding to time at 19ms in Figure 1C), the boost converter 150 may toggle the node GSW between 0V and a high select level 152 of 1.5V. Increasing the maximum voltage that the node GSW is set to or pulsed to during the switch-on phase reduces the resistance of the switch transistor 188 and increases the switch-on current through the switch transistor 188 during the switch-on phase.

During the recovery phase and while the node OUT is less than the second threshold 193 (e.g., is less than 20V), the boost converter 150 in Figure 1A may toggle the node GSW between 0V and the high select level 152 of 1.5V. Then, after the node OUT rises above the second threshold 193 at time T5 (e.g., corresponding to time at 22ms in Figure 1C), the boost converter 150 may toggle the node GSW between 0V and the low select level 153 of 1.2V. Decreasing the maximum voltage that the node GSW is set to during the switch-on phase increases the resistance of the switch transistor 188 and reduces the switch-on current through the switch transistor 188 during the switch-on phase. A reduced switch-on current reduces the amount of current drawn from the battery 102. In some cases, the second threshold 193 comprises a voltage level that is greater than the first threshold 192. In other cases, the second threshold 193 comprises a voltage level that is less than or equal to the first threshold 192.

In another embodiment, during the illumination phase and while the node OUT is greater than the second threshold 193 (e.g., is greater than 20V), the boost converter 150 in Figure 1A may toggle the node GSW between 0V and 1.2V. Then, after the node OUT falls below the second threshold 193, the boost converter 150 may toggle the node GSW between 0V and 1.5V. During the recovery phase and while the node OUT is less than the first threshold 192 (e.g., is less than 18V), the boost converter 150 in Figure 1A may toggle the node GSW between 0V and 1.5V. Then, after the node OUT rises above the first threshold 192, the boost converter 150 may toggle the node GSW between 0V and 1.2V until the voltage of the output node OUT reaches 22V or for the remainder of the recovery phase. Decreasing the maximum voltage that the node GSW is set to or is pulsed to during the switch-on phase increases the resistance of the switch transistor 188 and reduces the switch-on current through the switch transistor 188 during the switch-on phase. A reduced switch-on current reduces the amount of current drawn from the battery 102. As the recovery phase may be significantly longer than the illumination phase, reducing the recovery rate for the voltage at node OUT may be within operational parameters for the boost converter 150. The nominal regulation level for the boost converter 150 may comprise 22V and the minimum voltage level for the node OUT during illumination operations may comprise 14V.

In some embodiments, the first threshold 192 may be set based on the minimum voltage level for the node OUT and the length of time for the illumination phase. A lower minimum voltage level for the node OUT (e.g., allowing a 12V minimum output voltage compared with a 14V minimum output voltage) may lead to a lower threshold level as more time is available for the voltage of the node OUT to fall to the minimum voltage level. A longer illumination phase may lead to a higher threshold level as a higher switch-on current may be required to prevent the voltage of the node OUT from falling to the minimum voltage level. The second threshold 193 may be set based on the length of time for the recovery phase. A longer recovery phase may lead to a reduced voltage level for the second threshold 193 as more time is available to recover back to the nominal regulation level.

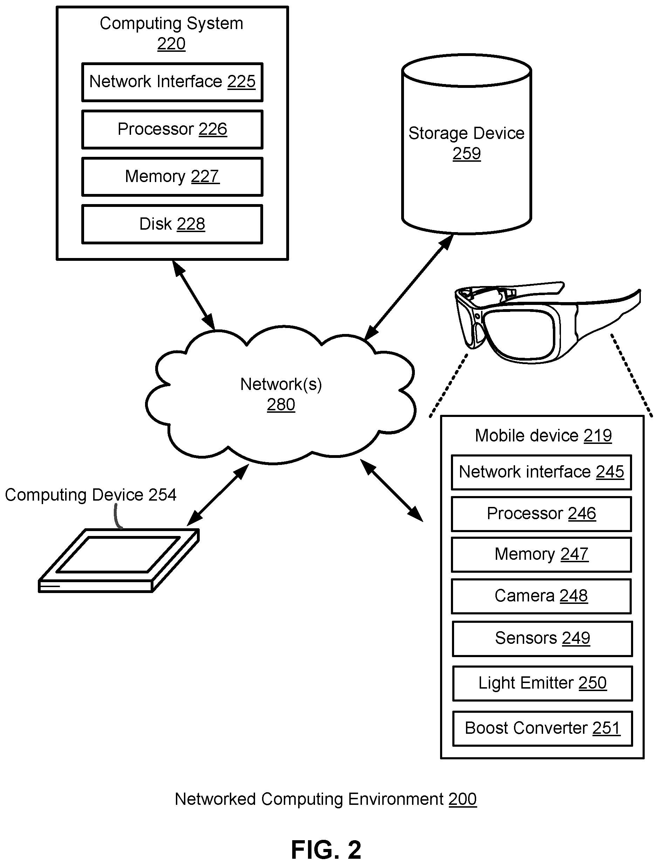

Figure 2 depicts one embodiment of a networked computing environment 200 in which the disclosed technology may be practiced. The networked computing environment 200 includes a computing system 220, storage device 259, mobile device 219, and a computing device 254 in communication with each other via one or more networks 280. The networked computing environment 200 may include various computing and storage devices interconnected through one or more networks 280. The networked computing environment 200 may correspond with or provide access to a cloud computing environment providing Software-as-a-Service (SaaS) or Infrastructure-as-a-Service (laaS) services. The one or more networks 280 may allow computing devices and/or storage devices to connect to and communicate with other computing devices and/or other storage devices. In some cases, the networked computing environment 200 may include other computing devices and/or other storage devices not shown. The other computing devices may include, for example, a mobile computing device, a non-mobile computing device, a server, a workstation, a laptop computer, a tablet computer, a desktop computer, or an information processing system. The other storage devices may include, for example, a storage area network storage device, a networked-attached storage device, a hard disk drive, a solid-state drive, a data storage system, or a cloud-based data storage system. The one or more networks 280 may include a cellular network, a mobile network, a wireless network, a wired network, a secure network such as an enterprise private network, an unsecure network such as a wireless open network, a local area network (LAN), a wide area network (WAN), the Internet, or a combination of networks.

In some embodiments, the computing devices within the networked computing environment 200 comprises real hardware computing devices or virtual computing devices, such as one or more virtual machines. The storage devices within the networked computing environment 200 may comprise real hardware storage devices or virtual storage devices, such as one or more virtual disks. The real hardware storage devices may include non-volatile and volatile storage devices.

The computing system 220 may comprise a distributed computing system or a system for providing a cloud-based computing environment. As depicted in Figure 2, the computing system 220 includes a network interface 225, processor 226, memory 227, and disk 228 all in communication with each other. The network interface 225, processor 226, memory 227, and disk 228 may comprise real components or virtualized components. In some cases, the network interface 225, processor 226, memory 227, and disk 228 may be provided by a virtualized infrastructure or a cloud-based infrastructure. Network interface 225 allows the computing system 220 to connect to one or more networks 280. Network interface 225 may include a wireless network interface and/or a wired network interface. Processor 226 allows the computing system 220 to execute computer readable instructions stored in memory 227 in order to perform processes described herein. Processor 226 may include one or more processing units, such as one or more CPUs, one or more GPUs, and/or one or more NPUs. Memory 227 may comprise one or more types of memory (e.g., RAM, SRAM, DRAM, EEPROM, Flash). Disk 228 may include a hard disk drive and/or a solid-state drive. Memory 227 and disk 228 may comprise hardware storage devices.

The computing device 254 may comprise a mobile computing device, such as a tablet computer, that allows a user to access a graphical user interface for the computing system 220. A user interface may be provided by the computing system 220 and displayed using a display screen of the computing device 254.

The networked computing environment 200 may provide a cloud computing environment for one or more computing devices. In one embodiment, the networked computing environment 200 may include a virtualized infrastructure that provides software, data processing, and/or data storage services to end users accessing the services via the networked computing environment. In one example, networked computing environment 200 may provide cloud-based applications to computing devices via the one or more networks 280.

One embodiment of mobile device 219 includes a network interface 245, processor 246, memory 247, camera 248, sensors 249, light emitter 250, and boost converter all in communication with each other. Network interface 245 allows mobile device 219 to connect to the one or more networks 280. Network interface 245 may include a wireless network interface, a modem, and/or a wired network interface. Processor 246 allows mobile device 219 to execute computer readable instructions stored in memory 247 in order to perform processes discussed herein. Camera 248 may capture color images and/or depth images of an environment. The mobile device 219 may include outward facing cameras that capture images of the environment and inward facing cameras that capture images of the end user of the mobile device. Sensors 249 may generate motion and/or orientation information associated with mobile device 219. In some cases, sensors 249 may comprise an inertial measurement unit (IMU). The light emitter 250 may comprise an illumination source and may include a laser or LED.

In some embodiments, mobile device 219 may provide a natural user interface (NUI) by employing light emitter 250, camera 248, sensors 249, and gesture recognition software running on processor 246. With a natural user interface, a person's body parts and movements may be detected, interpreted, and used to control various aspects of a computing application. In one example, the mobile device 219 device utilizing a natural user interface may detect that a person has performed a particular gesture in order to communicate with the mobile device 219. The boost converter 251 may correspond to the boost converter 150 in Figure 1A and the light emitter 250 may correspond to the light emitter 126 in Figure 1A.

In one example, mobile device 219 comprises a head-mounted display device (HMD) that provides an augmented reality environment or a mixed reality environment to an end user of the HMD. The HMD may comprise a video see-through and/or an optical see-through system. An optical see-through HMD worn by an end user may allow actual direct viewing of a real-world environment (e.g., via transparent lenses) and may, at the same time, project images of a virtual object into the visual field of the end user thereby augmenting the real-world environment perceived by the end user with the virtual object.

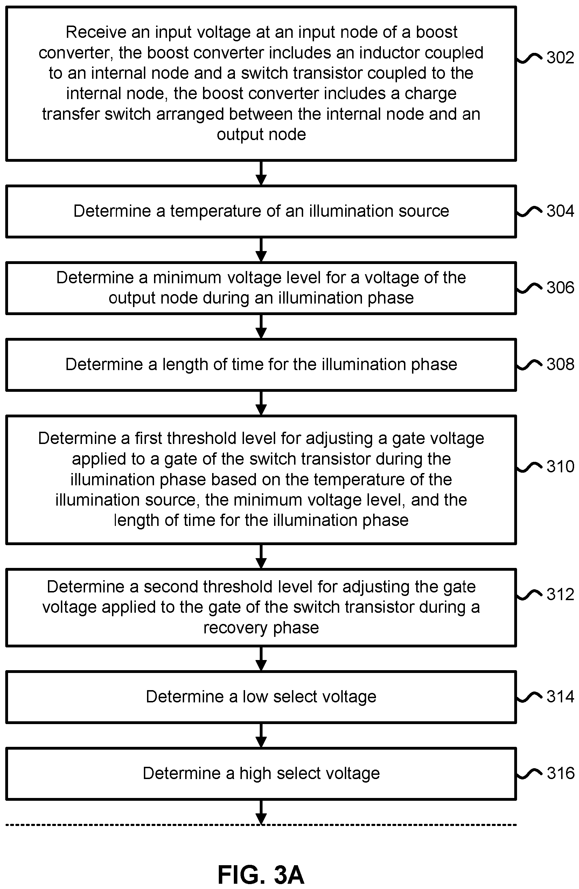

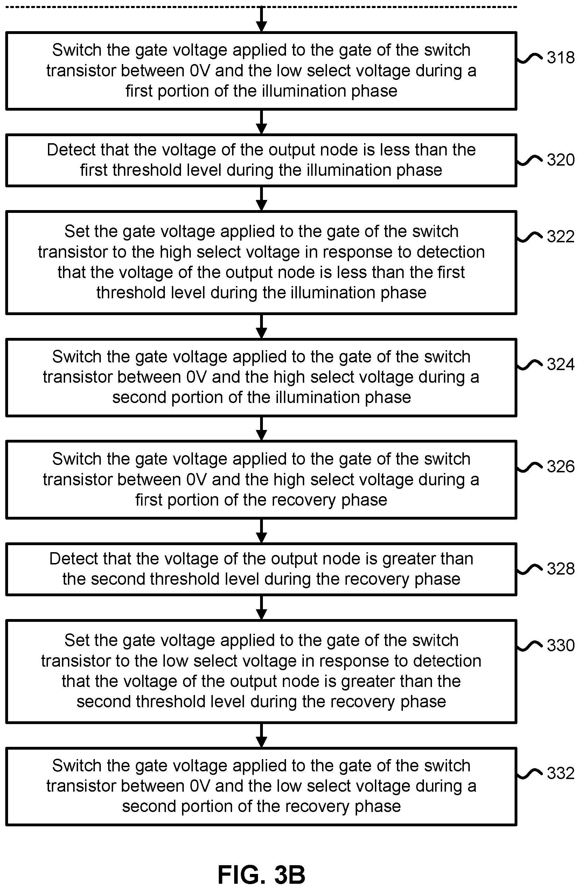

Figures 3A-3B depict a flowchart describing one embodiment of a process for operating a boost converter. In one embodiment, the process of Figures 3A-3B is performed by a boost converter, such as the boost converter 150 in Figure 1A. In another embodiment, the process of Figures 3A-3B is performed by the boost converter 251 in Figure 2A.

In step 302, an input voltage at an input node of a boost converter is received. The boost converter may correspond to the boost converter 150 in Figure 1A and the input node may correspond to the node IN of the boost converter 150. The input voltage may be provide via a current limited load switch in series with a battery. The boost converter includes an inductor coupled to an internal node and a switch transistor coupled to the internal node. The inductor may correspond to the inductor 186 in Figure 1A and the switch transistor may correspond to the switch transistor 188 in Figure 1A. The boost converter includes a charge transfer switch arranged between the internal node and an output node. The charge transfer switch may comprise a diode.

In step 304, a temperature of an illumination source is determined. The illumination source may correspond with the light emitter 126 in Figure 1A. The temperature of the illumination source may be acquired from a temperature sensor located in proximity to the illumination source. In step 306, a minimum voltage level for a voltage of the output node during an illumination phase is determined. The minimum voltage level for the voltage of the output node may be determined via a lookup table for a boost converter and may depend on a temperature of the illumination source and a load current requirement for the illumination source. In step 308, a length of time for the illumination phase is determined. The illumination phase may correspond to a length of time between the times T1 and T2 in Figure 1C. In step 310, a first threshold level for adjusting a gate voltage applied to a gate of the switch transistor during the illumination phase is determined based on the temperature of the illumination source, the minimum voltage level, and/or the length of time for the illumination phase. The first threshold level may correspond with the first threshold 192 in Figure 1C.

In step 312, a second threshold level for adjusting the gate voltage applied to the gate of the switch transistor during a recovery phase is determined. The second threshold level may correspond with the second threshold 193 in Figure 1C. In step 314, a low select voltage is determined. In step 316, a high select voltage is determined. The high select voltage may correspond with the high select level 152 in Figure 1D and the low select voltage may correspond with the low select level 153 in Figure 1D.

In step 318, the gate voltage applied to the gate of the switch transistor is switched or toggled between 0V (or the ground voltage) and the low select voltage during a first portion of the illumination phase. In step 320, it is detected that the voltage of the output node is less than the first threshold level during the illumination phase. The detection that the voltage of the output node (e.g., node OUT in Figure 1A) is less than the first threshold level may be performed by a comparator circuit, such as a comparator circuit within the controller 110 in Figure 1A.

In step 322, the gate voltage applied to the gate of the switch transistor is set to the high select voltage in response to detection that the voltage of the output node is less than the first threshold level during the illumination phase. In step 324, the gate voltage applied to the gate of the switch transistor is switched or toggled between 0V and the high select voltage during a second portion of the illumination phase. In step 326, the gate voltage applied to the gate of the switch transistor is switched between 0V and the high select voltage during a first portion of the recovery phase. In step 328, it is detected that the voltage of the output node is greater than the second threshold level during the recovery phase. In step 330, the gate voltage applied to the gate of the switch transistor is set to the low select voltage in response to detection that the voltage of the output node is greater than the second threshold level during the recovery phase. In step 332, the gate voltage applied to the gate of the switch transistor is switched (or pulsed) between 0V and the low select voltage during a second portion of the recovery phase.

At least one embodiment of the disclosed technology includes a boost converter including an inductor coupled to a first node, a switch transistor coupled to the first node, a charge transfer switch arranged between the first node and an output node, and a control circuit configured to: detect that a voltage of the output node is less than a first threshold level during an illumination phase for an illumination source; set a gate voltage applied to a gate of the switch transistor to a high select voltage in response to detection that the voltage of the output node is less than the first threshold level during the illumination phase; detect that the voltage of the output node is greater than a second threshold level during a recovery phase for the illumination source; and set the gate voltage applied to the gate of the switch transistor to a low select voltage in response to detection that the voltage of the output node is greater than the second threshold level during the recovery phase.

In some cases, the control circuit is configured to determine the first threshold level based on a temperature of the illumination source. In some cases, the control circuit is configured to determine the first threshold level based on a length of time for the illumination phase and/or a minimum voltage level for the voltage of the output node during the illumination phase.

At least one embodiment of the disclosed technology includes a method for operating a boost converter including an inductor and a switch transistor. The method comprising switching a gate voltage applied to a gate of the switch transistor between 0V and a low select voltage during a first portion of an illumination phase and detecting that a voltage of an output node of the boost converter is less than a first threshold level during the illumination phase. A charge transfer switch is arranged between a first node coupled to the switch transistor and the output node. The method further comprising setting the gate voltage applied to the gate of the switch transistor between 0V and a high select voltage greater than the low select voltage in response to detecting that the voltage of the output node is less than the first threshold level, switching the gate voltage applied to the gate of the switch transistor between 0V and the high select voltage greater than the low select voltage during a first portion of a recovery phase subsequent to the illumination phase, detecting that the voltage of the output node is greater than a second threshold level during the recovery phase, and setting the gate voltage applied to the gate of the switch transistor to the low select voltage in response to detecting that the voltage of the output node is greater than the second threshold level during the recovery phase.

In some cases, the method further comprises determining the first threshold level based on a temperature of the illumination source.

In some cases, the method further comprises determining the first threshold level based on a temperature of the boost converter.

In some cases, the method further comprises determining the first threshold level based on a length of time for the illumination phase and/or based on a minimum voltage level for the voltage of the output node during the illumination phase.

At least one embodiment of the disclosed technology includes a boost converter including an inductor coupled to a first node, a switch transistor coupled to the first node, a diode arranged between the first node and an output node, and a control circuit configured to: determine a first threshold level based on a temperature of an illumination source; detect that a voltage of the output node is less than the first threshold level during an illumination phase for the illumination source; switch a gate voltage applied to a gate of the switch transistor between 0V and a high select voltage in response to detection that the voltage of the output node is less than the first threshold level during the illumination phase; detect that the voltage of the output node is greater than a second threshold level during a recovery phase for the illumination source; and switch the gate voltage applied to the gate of the switch transistor between 0V and a low select voltage in response to detection that the voltage of the output node is greater than the second threshold level during the recovery phase.

In some cases, the high select voltage is greater than the low select voltage and the first threshold level is less than the second threshold level.

The disclosed technology may be described in the context of computer-executable instructions being executed by a computer or processor. The computer-executable instructions may correspond with portions of computer program code, routines, programs, objects, software components, data structures, or other types of computer-related structures that may be used to perform processes using a computer. Computer program code used for implementing various operations or aspects of the disclosed technology may be developed using one or more programming languages, including an object oriented programming language such as Java or C++, a function programming language such as Lisp, a procedural programming language such as the "C" programming language or Visual Basic, or a dynamic programming language such as Python or JavaScript. In some cases, computer program code or machine-level instructions derived from the computer program code may execute entirely on an end user's computer, partly on an end user's computer, partly on an end user's computer and partly on a remote computer, or entirely on a remote computer or server.

The flowcharts and block diagrams in the figures provide illustrations of the architecture, functionality, and operation of possible implementations of systems, methods, and computer program products according to various aspects of the disclosed technology. In this regard, each step in a flowchart may correspond with a program module or portion of computer program code, which may comprise one or more computer-executable instructions for implementing the specified functionality. In some implementations, the functionality noted within a step may occur out of the order noted in the figures. For example, two steps shown in succession may, in fact, be executed substantially concurrently, or the steps may sometimes be executed in the reverse order, depending upon the functionality involved. In some implementations, steps may be omitted and other steps added without departing from the spirit and scope of the present subject matter. In some implementations, the functionality noted within a step may be implemented using hardware, software, or a combination of hardware and software. As examples, the hardware may include microcontrollers, microprocessors, field programmable gate arrays (FPGAs), and electronic circuitry.

For purposes of this document, the term "processor" may refer to a real hardware processor or a virtual processor, unless expressly stated otherwise. A virtual machine may include one or more virtual hardware devices, such as a virtual processor and a virtual memory in communication with the virtual processor.

For purposes of this document, it should be noted that the dimensions of the various features depicted in the figures may not necessarily be drawn to scale.

For purposes of this document, reference in the specification to "an embodiment," "one embodiment," "some embodiments," "another embodiment," and other variations thereof may be used to describe various features, functions, or structures that are included in at least one or more embodiments and do not necessarily refer to the same embodiment unless the context clearly dictates otherwise.

For purposes of this document, a connection may be a direct connection or an indirect connection (e.g., via another part). In some cases, when an element is referred to as being connected or coupled to another element, the element may be directly connected to the other element or indirectly connected to the other element via intervening elements. When an element is referred to as being directly connected to another element, then there are no intervening elements between the element and the other element.

For purposes of this document, the term "based on" may be read as "based at least in part on."

For purposes of this document, without additional context, use of numerical terms such as a "first" object, a "second" object, and a "third" object may not imply an ordering of objects, but may instead be used for identification purposes to identify or distinguish separate objects.

For purposes of this document, the term "set" of objects may refer to a "set" of one or more of the objects.

For purposes of this document, the phrases "a first object corresponds with a second object" and "a first object corresponds to a second object" may refer to the first object and the second object being equivalent, analogous, or related in character or function.

For purposes of this document, the term "or" should be interpreted in the conjunctive and the disjunctive. A list of items linked with the conjunction "or" should not be read as requiring mutual exclusivity among the items, but rather should be read as "and/or" unless expressly stated otherwise. The terms "at least one," "one or more," and "and/or," as used herein, are open-ended expressions that are both conjunctive and disjunctive in operation. The phrase "A and/or B" covers embodiments having element A alone, element B alone, or elements A and B taken together. The phrase "at least one of A, B, and C" covers embodiments having element A alone, element B alone, element C alone, elements A and B together, elements A and C together, elements B and C together, or elements A, B, and C together. The indefinite articles "a" and "an," as used herein, should typically be interpreted to mean "at least one" or "one or more," unless expressly stated otherwise.

The various embodiments described above can be combined to provide further embodiments. These and other changes can be made to the embodiments in light of the above-detailed description. In general, in the following claims, the terms used should not be construed to limit the claims to the specific embodiments disclosed in the specification and the claims, but should be construed to include all possible embodiments along with the full scope of equivalents to which such claims are entitled. Accordingly, the claims are not limited by the disclosure.

**The following is a list of further preferred embodiments of the invention:**
Embodiment 1. An apparatus, comprising:
   a boost converter including an inductor coupled to a first node, a switch transistor coupled to the first node, a charge transfer switch arranged between the first node and an output node, and a control circuit configured to:
   detect that a voltage of the output node is less than a first threshold level during an illumination phase for an illumination source;
   set a gate voltage applied to a gate of the switch transistor to a high select voltage in response to detection that the voltage of the output node is less than the first threshold level during the illumination phase;
   detect that the voltage of the output node is greater than a second threshold level during a recovery phase for the illumination source; and
   set the gate voltage applied to the gate of the switch transistor to a low select voltage in response to detection that the voltage of the output node is greater than the second threshold level during the recovery phase.
Embodiment 2. The apparatus of embodiment 1, wherein:
   the control circuit is configured to toggle the gate voltage applied to the gate of the switch transistor between 0V and the high select voltage during the illumination phase in response to detection that the voltage of the output node is less than the first threshold level.
Embodiment 3. The apparatus of embodiment 1, wherein:
   the control circuit is configured to toggle the gate voltage applied to the gate of the switch transistor between 0V and the low select voltage less than the high select voltage during the illumination phase prior to detection that the voltage of the output node is less than the first threshold level.
Embodiment 4. The apparatus of embodiment 1, wherein:
   the control circuit is configured to pulse the gate voltage applied to the gate of the switch transistor between 0V and the low select voltage during the recovery phase in response to detection that the voltage of the output node is greater than the second threshold level.
Embodiment 5. The apparatus of embodiment 1, wherein:
   the control circuit is configured to pulse the gate voltage applied to the gate of the switch transistor between 0V and the high select voltage greater than the low select voltage during the recovery phase prior to detection that the voltage of the output node is greater than the second threshold level.
Embodiment 6. The apparatus of embodiment 1, wherein:
   the charge transfer switch comprises a diode;
   the inductor is directly connected to the first node;
   the switch transistor is directly connected to the first node; and
   the switch transistor comprises an NMOS transistor.
Embodiment 7. The apparatus of embodiment 1, wherein:
   the charge transfer switch is configured to prevent current from flowing from the output node to the first node.
Embodiment 8. The apparatus of embodiment 1, wherein:
   the high select voltage is greater than the low select voltage; and
   the first threshold level is greater than the second threshold level.
Embodiment 9. The apparatus of embodiment 1, wherein:
   the control circuit is configured to determine the first threshold level based on a temperature of the illumination source.
Embodiment 10. The apparatus of embodiment 1, wherein:
   the control circuit is configured to determine the first threshold level based on a length of time for the illumination phase and a minimum voltage level for the voltage of the output node during the illumination phase.
Embodiment 11. A method for operating a boost converter including an inductor and a switch transistor, comprising:
   switching a gate voltage applied to a gate of the switch transistor between 0V and a low select voltage during a first portion of an illumination phase;
   detecting that a voltage of an output node of the boost converter is less than a first threshold level during the illumination phase, a charge transfer switch is arranged between a first node coupled to the switch transistor and the output node;
   setting the gate voltage applied to the gate of the switch transistor between 0V and a high select voltage greater than the low select voltage in response to detecting that the voltage of the output node is less than the first threshold level;
   switching the gate voltage applied to the gate of the switch transistor between 0V and the high select voltage greater than the low select voltage during a first portion of a recovery phase subsequent to the illumination phase;
   detecting that the voltage of the output node is greater than a second threshold level during the recovery phase; and
   setting the gate voltage applied to the gate of the switch transistor to the low select voltage in response to detecting that the voltage of the output node is greater than the second threshold level during the recovery phase.
Embodiment 12. The method of embodiment 11, further comprising:
   determining the first threshold level based on a temperature of the illumination source.
Embodiment 13. The method of embodiment 11, further comprising:
   determining the first threshold level based on a temperature of the boost converter.
Embodiment 14. The method of embodiment 11, further comprising:
   determining the first threshold level based on a length of time for the illumination phase.
Embodiment 15. The method of embodiment 11, further comprising:
   determining the first threshold level based on a minimum voltage level for the voltage of the output node during the illumination phase.
Embodiment 16. The method of embodiment 11, wherein:
   the charge transfer switch comprises a diode;
   the inductor is directly connected to the first node;
   the switch transistor is directly connected to the first node; and
   the switch transistor comprises an NMOS transistor.
Embodiment 17. The method of embodiment 11, wherein:
   the charge transfer switch is configured to prevent current from flowing from the output node to the first node.
Embodiment 18. The method of embodiment 11, wherein:
   the first threshold level is greater than the second threshold level.
Embodiment 19. A system, comprising:
   a boost converter including an inductor coupled to a first node, a switch transistor coupled to the first node, a diode arranged between the first node and an output node, and a control circuit configured to:
   determine a first threshold level based on a temperature of an illumination source;
   detect that a voltage of the output node is less than the first threshold level during an illumination phase for the illumination source;
   switch a gate voltage applied to a gate of the switch transistor between 0V and a high select voltage in response to detection that the voltage of the output node is less than the first threshold level during the illumination phase;
   detect that the voltage of the output node is greater than a second threshold level during a recovery phase for the illumination source; and
   switch the gate voltage applied to the gate of the switch transistor between 0V and a low select voltage in response to detection that the voltage of the output node is greater than the second threshold level during the recovery phase.
Embodiment 20. The method of embodiment 19, wherein:
   the high select voltage is greater than the low select voltage; and
   the first threshold level is less than the second threshold level.

## Claims

1. An apparatus, comprising:
a boost converter (150) including an inductor (186) coupled to a first node, a switch transistor (188) coupled to the first node, a charge transfer switch (122) arranged between the first node and an output node, and a control circuit (110) configured to:
detect (320) that a voltage of the output node is less than a first threshold level during an illumination phase for an illumination source;
set (322) a gate voltage applied to a gate of the switch transistor to a high select voltage in response to detection that the voltage of the output node is less than the first threshold level during the illumination phase;
detect (328) that the voltage of the output node is greater than a second threshold level during a recovery phase for the illumination source; and
set (330) the gate voltage applied to the gate of the switch transistor to a low select voltage in response to detection that the voltage of the output node is greater than the second threshold level during the recovery phase.

2. The apparatus of claim 1, wherein:
the control circuit is configured to toggle the gate voltage applied to the gate of the switch transistor between 0V and the high select voltage during the illumination phase in response to detection that the voltage of the output node is less than the first threshold level.

3. The apparatus of claim 1, wherein:
the control circuit is configured to toggle the gate voltage applied to the gate of the switch transistor between 0V and the low select voltage less than the high select voltage during the illumination phase prior to detection that the voltage of the output node is less than the first threshold level.

4. The apparatus of claim 1, wherein:
the control circuit is configured to pulse the gate voltage applied to the gate of the switch transistor between 0V and the low select voltage during the recovery phase in response to detection that the voltage of the output node is greater than the second threshold level.

5. The apparatus of claim 1, wherein:
the control circuit is configured to pulse the gate voltage applied to the gate of the switch transistor between 0V and the high select voltage greater than the low select voltage during the recovery phase prior to detection that the voltage of the output node is greater than the second threshold level.

6. The apparatus of any of claims 1-5, wherein:
the charge transfer switch comprises a diode;
the inductor is directly connected to the first node;
the switch transistor is directly connected to the first node; and
the switch transistor comprises an NMOS transistor, and/or
wherein:
the charge transfer switch is configured to prevent current from flowing from the output node to the first node.

7. The apparatus of any of claims 1-6, wherein:
the high select voltage is greater than the low select voltage; and
the first threshold level is greater than the second threshold level.

8. The apparatus of claim 1, wherein:
the control circuit is configured to determine the first threshold level based on a temperature of the illumination source, or
wherein:
the control circuit is configured to determine the first threshold level based on a length of time for the illumination phase and a minimum voltage level for the voltage of the output node during the illumination phase.

9. A method for operating a boost converter including an inductor and a switch transistor, comprising:
switching (318) a gate voltage applied to a gate of the switch transistor between 0V and a low select voltage during a first portion of an illumination phase;
detecting (320) that a voltage of an output node of the boost converter is less than a first threshold level during the illumination phase, a charge transfer switch is arranged between a first node coupled to the switch transistor and the output node;
setting (322) the gate voltage applied to the gate of the switch transistor between 0V and a high select voltage greater than the low select voltage in response to detecting that the voltage of the output node is less than the first threshold level;
switching (326) the gate voltage applied to the gate of the switch transistor between 0V and the high select voltage greater than the low select voltage during a first portion of a recovery phase subsequent to the illumination phase;
detecting (328) that the voltage of the output node is greater than a second threshold level during the recovery phase; and
setting (330) the gate voltage applied to the gate of the switch transistor to the low select voltage in response to detecting that the voltage of the output node is greater than the second threshold level during the recovery phase.

10. The method of claim 9, further comprising:
determining the first threshold level based on a temperature of the illumination source.

11. The method of claim 9, further comprising:
determining the first threshold level based on a temperature of the boost converter, or
further comprising:
determining the first threshold level based on a length of time for the illumination phase, or
further comprising:
determining the first threshold level based on a minimum voltage level for the voltage of the output node during the illumination phase.

12. The method of any of claims 9 to 11, wherein:
the charge transfer switch comprises a diode;
the inductor is directly connected to the first node;
the switch transistor is directly connected to the first node; and
the switch transistor comprises an NMOS transistor.

13. The method of any of claims 9 to 12, wherein:
the charge transfer switch is configured to prevent current from flowing from the output node to the first node, and/or
wherein:
the first threshold level is greater than the second threshold level.

14. A system, comprising:
a boost converter (150) including an inductor (186) coupled to a first node, a switch transistor (188) coupled to the first node, a diode (123) arranged between the first node and an output node, and a control circuit (110) configured to:
determine (314) a first threshold level based on a temperature of an illumination source;
detect (320) that a voltage of the output node is less than the first threshold level during an illumination phase for the illumination source;
switch (324) a gate voltage applied to a gate of the switch transistor between 0V and a high select voltage in response to detection that the voltage of the output node is less than the first threshold level during the illumination phase;
detect (328) that the voltage of the output node is greater than a second threshold level during a recovery phase for the illumination source; and
switch (332) the gate voltage applied to the gate of the switch transistor between 0V and a low select voltage in response to detection that the voltage of the output node is greater than the second threshold level during the recovery phase.

15. The method of claim 14, wherein:
the high select voltage is greater than the low select voltage; and
the first threshold level is less than the second threshold level.
